# EUROPEAN PATENT SPECIFICATION

(11) **EP 1 014 412 B1**
(45) Date of publication and mention of the grant of the patent: **10.11.2004**
(21) Application number: 99204081.6
(22) Date of filing: 02.12.1999
(51) Int. Cl.: H01H 57/00, H01H 83/02

(54) **Bistable actuator**
Bistabile Betätigungsvorrichtung
Dispositif bistable de commande

(30) Priority: 24.12.1998 IT MI982829
(43) Date of publication of application: 28.06.2000
(73) Proprietor: ABB Service S.r.l, 20124 Milano (IT)
(72) Inventor: Sciacca, Aldo, 20097 San Donato Milanese, MI (IT); Mandurino, Pietro, 40141 Bologna (IT); Colonna, Donato, 20137 Milano (IT); Moriconi, Franco, 20097 San Donato Milanese, MI (IT)
(74) Representative: Giavarini, Francesco

(56) References cited:
- EP-A- 0 548 731
- US-A- 4 383 195

## Description

The present invention relates to a low-energy bistable actuator, particularly for residual-current devices such as for example residual-current circuit breakers.

It is known that a residual-current circuit breaker is an automatic circuit breaker for AC circuits which opens when the vector sum of the currents in the conductors of the circuit, which is zero in normal conditions, exceeds a preset value.

Residual-current circuit breakers are meant to prevent metallic parts, such as the enclosures of appliances and the metallic masses of the protected area, connected to an earth system apparatus of suitable resistance, from becoming live (indirect protection) and, if sufficiently sensitive and fast-acting, can in certain conditions also provide protection against contact with normally live parts (direct protection).

The main characteristic of residual-current circuit breakers is that they achieve extremely short circuit opening and closure times.

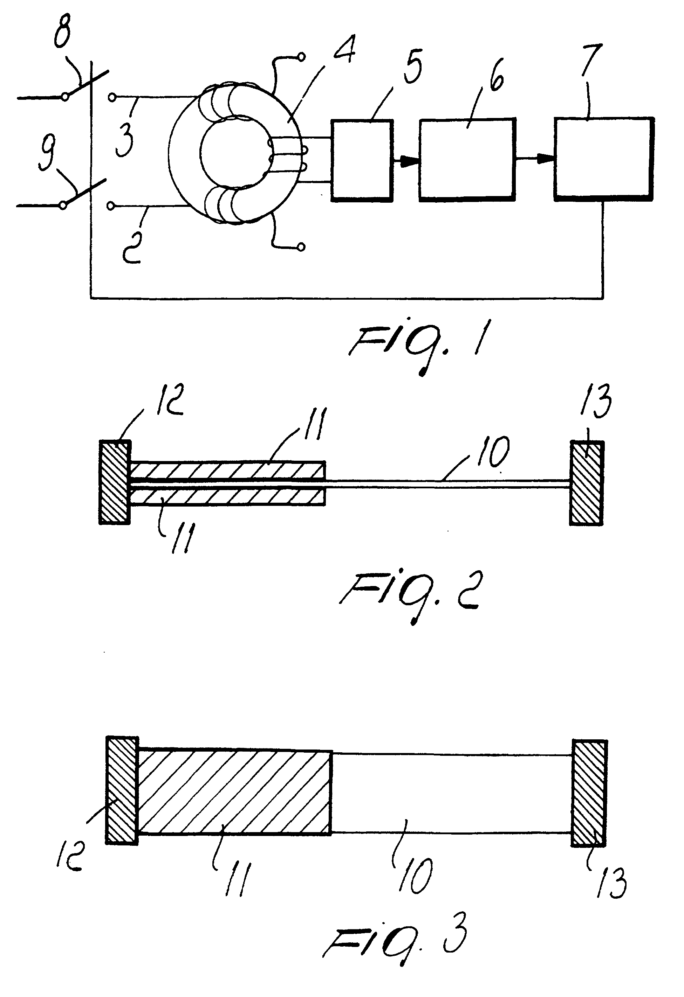

A residual-current circuit breaker is shown generically in Figure 1. Said circuit breaker comprises a sensor 1 for detecting the residual fault current, generally constituted by a magnetic core through which the neutral 2 and the phase 3 pass and are then input-connected to a load (not shown), and by a secondary winding 4 across which a voltage is generated when the fault current is present. An electronic coupling circuit 5, which is supplied by the voltage generated across the secondary winding, is provided between the current sensor 4 and an actuator 6.

The residual-current circuit breaker further comprises a release or disengagement mechanism 7 which is actuated by the actuator 6 and opens the contacts 8 and 9 of the circuit if there is an earth fault current. US 4 383 195 discloses a piezoelectric actuator including a piezoelectric element; EP 0 548 731 discloses a residual current device.

Conventional actuators used in a residual-current circuit breaker are of the electromagnetic type, e. g. electromagnetic relays of the demagnetization type, and have the following drawbacks.

They are sensitive to magnetic fields and this alters their operation. For example, the presence of an electromagnetic field can cause an unwanted and unwarranted actuation of the actuator, or an external magnetic field can alter the magnetization of the electromagnetic relay, consequently altering the sensitivity of the residual-current circuit breaker.

Said actuators are also sensitive to impacts and vibrations, are mechanically complicated to provide and are expensive.

The aim of the present invention is to provide a bistable actuator for residual-current devices, which is insensitive to external magnetic fields.

Within the scope of this aim, an object of the present invention is to provide a bistable actuator for residual-current devices, which provides assured intervention with extremely short actuation times.

Another object of the present invention is to provide a bistable actuator for residual-current devices, which requires a low triggering energy, so as to make the actuator applicable in self-powered residual-current circuit breakers in which the small amount of energy available is derived exclusively from the earth fault current.

Another object of the present invention is to provide a bistable actuator for residual-current devices, which is substantially insensitive to impacts and vibrations.

Another object of the present invention is to provide a bistable actuator for residual-current devices, which is highly reliable, relatively easy to manufacture and at competitive costs.

This aim, these objects and others which will become apparent hereinafter are achieved by a bistable actuator for residual-current devices, as defined in claim 1.

Further characteristics and advantages of the present invention will become apparent from the following detailed description of preferred but not exclusive embodiments of the actuator according to the invention, illustrated only by way of non-limitative example in the accompanying drawings, wherein:
Figure 1 is a schematic block diagram of a residual-current circuit breaker;
Figure 2 is a schematic side view of a bistable actuator not according to the present invention;
Figure 3 is a plan view of Figure 2, illustrating a bistable actuator not according to the present invention;
Figure 4 is a view of a bistable actuator not according to the present invention;
Figure 5 is a view of a bistable actuator not according to the present invention;
Figure 6 is a view of a bistable actuator not according to the present invention:
Figure 7 is a view of a bistable actuator not according to the present invention:
Figure 8 is a view of a bistable actuator not according to the invention;
Figure 9 is a view of a bistable actuator not according to the invention:
Figure 10 is a view of a bistable actuator not according to the invention;
Figure 11 is a view of an actuator not according to the invention; and
Figure 12 is a view of a bistable actuator not according to the present invention:
Figure 13 is a view of the actuator according to the invention.

With reference to the above figures, and particularly to Figures 2 to 13, the bistable actuator comprises a metallic lamina 10, which has a substantially rectangular shape; at least one layer of piezoelectric material 11 is applied on at least one face of the lamina and on at least one portion thereof; in particular, in a preferred embodiment, the layer of piezoelectric material 11 is fixed in correspondance of a first end of the lamina 10.

The first end of the metallic lamina 10, on which the layer of piezoelectric material 11 is arranged, is inserted with an interlock coupling in a supporting element 12.

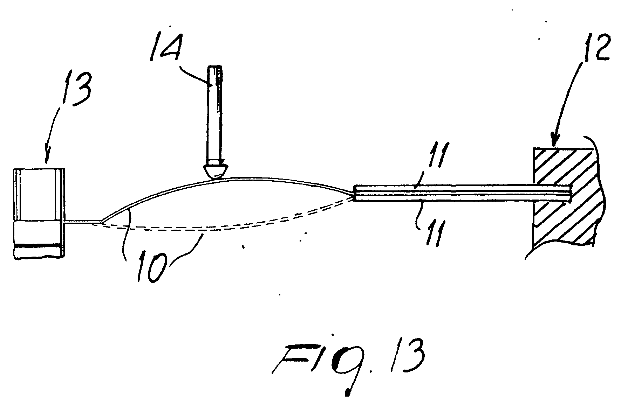

A second end of the lamina, which is opposite to the first end is instead rigidly coupled to a supporting element 13 so as to prevent any movement of the rigidly coupled ends of the lamina 10. In this situation, the lamina 10 is positioned in a first stable equilibrium position, as shown in dashed lines in figure 13.

The supporting elements 12 and 13 are monolithic; alternatively, they can be provided by two different elements.

Preferably, two layers 11 of piezoelectric material are arranged on opposite surfaces of the lamina 10 in correspondance of said first end; these layers 11 are positioned substantially parallel to each other in a bimorph configuration, with the metallic lamina 10 interposed between them; alternatively, the piezoelectric layers 11 can be positioned superposed on a same face of the lamina 10.

A portion of the piezoelectric layers 11 is inserted with an interlock coupling, together with the lamina 10, in the supporting element 12. This allows to have a rigid coupling in which the piezoelectric elements 11 behave like a pivot and transfer in an optimum manner the bending moment to the free part of the lamina 10, i.e. the portion of the lamina 10 which is comprised between the first end which is associated with the piezoelectric layers 11 and the second end which is coupled to the supporting structure.

The operation of the bistable actuator is as follows.

The lamina is subjected to an axial compressing stress, assuming the deformed configuration shown in dashed lines in figure 13. The deflection of the lamina 10, i.e. the deformation with respect to the non-deformed configuration, on the free tip of the piezoelectric layers 1 is much smaller than the deflection on the free part of the lamina, because the piezoelectric part 11 is much more rigid than the free part of the lamina 10.

In the presence of an earth fault current, an electrical activation signal for the piezoelectric layers is produced, causing their deformation. The portion of metallic lamina 10 on which the piezoelectric elements are fixed flexes, and the deflection on the end of the piezoelectric elements that is not inserted with an interlock coupling reduces and moves beyond the imaginary line of the non-deformed configuration. In this manner, the lamina 10 becomes unstable and snaps, producing actuation, to a second stable position, shown in continuos lines in figure 13. Conveniently, this actuation entails, for example, the actuation of a pin 14 to which the release device of a residual-current circuit breaker is connected.

It should he noted that the end of the lamina 10 on which the layers of piezoelectric material 11 are arranged is inserted with an interlock coupling in the supporting element in order to maximize the stability of the actuator and the flexing of the piezoelectric elements at the end that is not inserted in the supporting element.

The bistable actuator, thanks to the use of piezoelectric material, is inherently immune to magnetic fields. Moreover, the piezoelectric layers 11 are glued to the lamina 10 and this ensures a highly compact structure which is mechanically simple to provide, accordingly providing a cost reduction with respect to conventional actuators.

The structure of the actuator thus conceived is also bistable: this facilitates a low snap-action energy which makes the actuator applicable in self-powered residual-current circuit breakers, in which the small amount of available energy is derived exclusively from the earth fault current.

Moreover, according to the invention, shown in figure 13, the ends of the lamina 10 are coupled to the supporting structure 12 in mutually staggered positions with reference to a median plane of the lamina in a non-deformed configuration.

This allows to reduce the energy required to make the lamina snap from one configuration to the other.

The lamina 10 can advantageously be made of superelastic material, so as to ensure, for an equal provided stroke and force, a lower snap-action energy requirement. This choice becomes necessary when the length of the actuator decreases below a certain value.

In addition to being made of superelastic or pseudoelastic material, the lamina 10 can also be made of linear superelastic material.

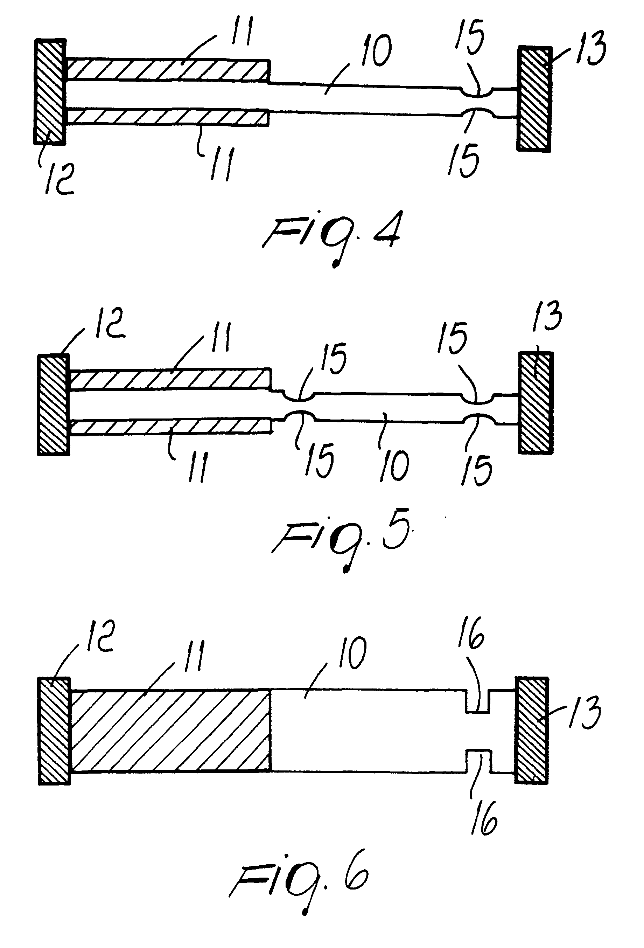

Despite its bistable nature, the actuator can in any case be rendered sufficiently insensitive to impacts and vibrations by means of appropriate shapes or local reductions in the thickness of the lamina 10, as shown in detail in Figures 4 to 12.

Since in a residual-current circuit breaker, especially of the self-powered type, there is a very small amount of energy available to provide the actuation of the actuator yet rapid intervention times are required, it is therefore necessary for the bistable lamina 10 to meet certain requirements in terms of rigidity, mass and dimensions.

In view of the above, it is therefore necessary to minimize the driving energy of the actuator, to increase its mechanical stability and optimize its force-displacement characteristic.

For this purpose, at least a portion of the lamina 10 proximate to the second end which is rigidly coupled to the supporting element 13, is shaped conveniently, so as to provide a sort of functional hinges; in particular, this shaped portion can be provided so as to decrease in width and thickness.

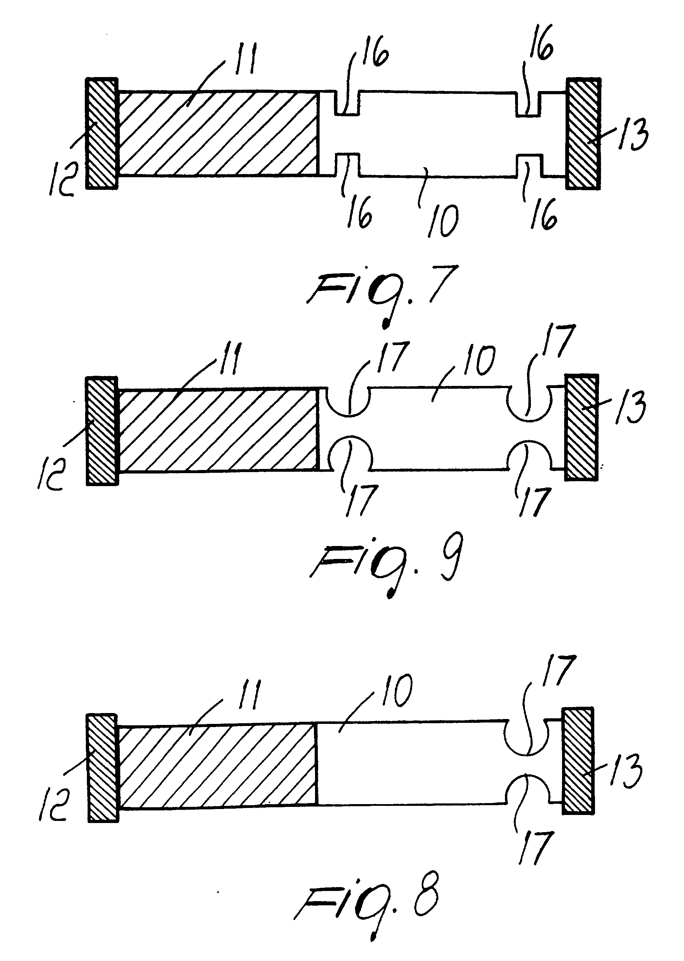

As shown in Figure 4 and in Figure 5, which are side views of an actuator not according to the invention, it is possible to provide a thickness reduction of the cross-section of the lamina 10, in an area designated by the reference numeral 15; the tickness reduction can be provided only in a portion of the metallic lamina 10 proximate to said second end, or also in a region of the lamina which is adjacent to the piezoelectric layers 11.

With reference to figure 6-12, other embodiments of an actuator not according to the invention are illustrated, in which the metallic lamina 10 is shaped in order to present at least one portion with a reduced width. In particular, the reduction of the width can be provided by suitably shaped recesses 16; these recesses, can be provide only in correspondance of a portion of the lamina 10 which is adjacent to the second end, as shown in figure 6, or also in correspondance of a portion which is adjacent to the piezoelectric layers 11, as shown in figure 7. Preferably, two recesses 16 are provided for each interested portion, and they can have, for example, a square profile as illustrated in figures 6 and 7, or a rounded profile, as shown in figures 8 and 9.

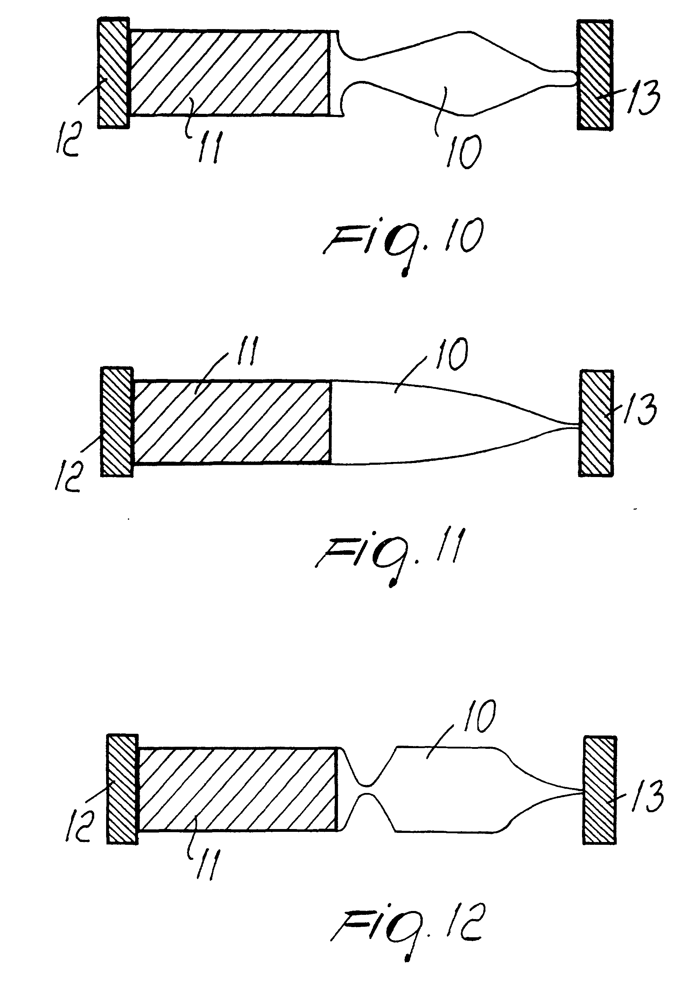

Figures 10, 11 and 12 are views of actuators not according to the invention, in which at least one portion of the lamina 10 is shaped so as to have a reduced width. In particular, as shown in figure 11, the lamina 10 has a portion, which is adjacent to the second end, with a tapered profile. As an alternative, also the portion of the lamina 10 that is adjacent to the region where the piezoelectric layer or layers 11 are arranged can be shaped so as to have a tapered profile, as illustrated in figures 10 and 12.

In practice it has been observed that the actuator fully achieves the intended aim and objects, since it allows to achieve extremely short actuation times with very low energy consumption.

In the presence of an earth fault current, if the actuator is used in a residual-current circuit breaker, an electrical activation signal for the piezoelectric elements is produced, causing their deformation. The portion of metallic lamina on which the piezoelectric elements are glued flexes, and during said flexing it causes the free part of the lamina to snap to the second stable position.

The arrangement of the ends of the metallic lamina 10 at different levels allows to reduce the required actuation energy.

The actuator according to the invention can be advantageously used in various kind of devices; in particular, it can be used in a residual-current circuit breaker as previously described, or in a residual-current block, i.e. a block which is generally coupled to a thermomagnetic circuit breaker. Alternatively, it can be used in other types of circuit breaker or interruption devices.

## Claims

1. A bistable actuator for residual-current devices, comprising:
- a supporting element (12);
- a metallic lamina (10) that is provided with at least one layer of piezoelectric material (11) on at least one of its faces at a first end thereof, said first end being inserted with an interlock coupling in said supporting element (12), a second end of said lamina (10), which is opposite to said first end, being rigidly coupled to the supporting element so as to keep said lamina (10) in a first stable equilibrium position, **characterized in that** said first end and said second end of said metallic lamina (10) are coupled to said supporting element in mutually staggered positions with reference to a median plane of the lamina (10) in a non-deformed configuration.

2. The bistable actuator according to claim 1, **characterized in that** said layer of piezoelectric material (11) is inserted with an interlock coupling, for at least a portion, with said lamina (10) in said supporting element (12).

3. The bistable actuator according to claim 1, **characterized in that** it comprises two layers of piezoelectric material (11) fixed to the two faces of said lamina (10) in correspondance of said first end.

4. The bistable actuator according to claim 1, **characterized in that** said lamina (10) has, at least in correspondance of a portion which is adjacent to said second end, a reduced width.

5. The bistable actuator according to claim 4, **characterized in that** said metallic lamina (10) has, in correspondance of said portion which is adjacent to said second end, two recesses (16).

6. The bistable actuator according to one or more of the preceding claims, **characterized in that** said lamina (10) has, in correspondance of a portion which is adjacent to said layer of piezoelectric material (11), a reduced width.

7. The bistable actuator according to claim 6, **characterized in that** said metallic lamina (10) has two recesses (16) in correspondance of said portion which is adjacent to said layer of piezoelectric material (11).

8. The bistable actuator according to one or more of the claims from 1 to 3, **characterized in that** said metallic lamina (10) has, in correspondance of a portion which is adjacent to said second end, a tapered profile.

9. The bistable actuator according to claim 8, **characterized in that** said metallic lamina (10) has, in correspondance of a portion which is adjacent to said layer of piezoelectric material (11), a tapered profile.

10. The bistable actuator according to one or more of the claims from 1 to 3, **characterized in that** said metallic lamina (10) is shaped, at least in correspondance of a portion of the lamina (10) which is adjacent to said second end, so as to have a thinner transverse cross-section.

11. The bistable actuator according to one or more of the preceding claims, **characterized in that** said lamina is made of superelastic or pseudoelastic material.

12. A residual-current circuit breaker **characterized in that** it comprises a bistable actuator according to one or more of the preceding claims.

13. A residual-current block **characterized in that** it comprises a bistable actuator according to one or more of the claims from 1 to 11.

## Patentansprüche

1. Bistabiler Aktuator für Fehlerstromvorrichtungen umfassend:
- ein Stützelement (12);
- ein metallischen Plättchen (10), welches mit einer ersten Lage vom piezoelektrischen Material (11) auf wenigstens einer seiner Seiten an einem ersten Ende davon versehen ist, wobei das erste Ende in eine Verriegelungskopplung in diesem Stützelement eingefügt ist, ein zweites Endes des Plättchens (10), welches dem ersten Ende gegenüberliegt, wobei es fest mit dem Stützelement verbunden ist, um das Plättchen (10) in einer ersten stabilen Gleichgewichtsposition zu halten, **dadurch gekennzeichnet, dass** das erste Ende und das zweite Ende des metallischen Plättchens (10) mit dem Stützelement in beiderseitig gestapelten Positionen mit Bezug auf eine Medianebene des Plättchens (10) in einer nicht-verformten Konfiguration verbunden sind.

2. Bistabiler Aktuator gemäß Anspruch 1, **dadurch gekennzeichnet, dass** die Lage vom piezoelektrischen Material (11) mit einer Verriegelungskopplung für wenigstens einen Abschnitt mit diesem Plättchen (10) in diesem Stützelement (12) eingefügt ist.

3. Bistabiler Aktuator gemäß Anspruch 1 **dadurch gekennzeichnet, dass** er zwei Lagen von piezoelektrischen Material (11) aufweist, welche auf den beiden Seiten des Plättchens (10) in Entsprechung mit dem ersten Ende befestigt sind.

4. Bistabiler Aktautor gemäß Anspruch 1, **dadurch gekennzeichnet, dass** das Plättchen (10) wenigstens in Übereinstimmung mit einem Abschnitt der benachbart dem zweiten Ende ist, eine verminderte Breite aufweist.

5. Bistabiler Aktautor gemäß Anspruch 4, **dadurch gekennzeichnet, dass** das metallische Plättchen (10) in Übereinstimmung mit dem Abschnitt, welcher zu dem zweiten Ende benachbart ist, zwei Einbuchtungen (16) aufweist.

6. Bistabiler Aktuator gemäß einem oder mehreren der vorhergehenden Ansprüche, **dadurch gekennzeichnet, dass** das Plättchen (10) in Übereinstimmung mit einem Abschnitt, welcher zu der Lage vom piezoelektrischen Material (11) benachbart ist, eine verminderte Breite aufweist.

7. Bistabiler Aktuator gemäß Anspruch 6, **dadurch gekennzeichnet, dass** das metallische Plättchen (10) zwei Einbuchtungen (16) in Übereinstimmung mit einem Abschnitt aufweist, welcher benachbart zu der Lage vom piezoelektrischen Material (11) ist.

8. Bistabiler Aktuator gemäß einem oder mehreren der Ansprüche 1 bis 3, **dadurch gekennzeichnet, dass** das metallische Plättchen (10) in Übereinstimmung mit einem Abschnitt, welcher benachbart zu den zweiten Ende ist, ein abgeschrägtes Profil aufweist.

9. Bistabiler Aktautor gemäß Anspruch 8, **dadurch gekennzeichnet, dass** das metallische Plättchen (10) in Übereinstimmung mit einem Abschnitt, welcher zu der Lage des piezoelektrischen Materials (11) benachbart ist, ein abgeschrägtes Profil aufweist.

10. Bistabiler Aktautor gemäß einem oder mehreren der Ansprüche 1 bis 3, **dadurch gekennzeichnet, dass** das metallische Plättchen (10) wenigstens in Übereinstimmung mit einem Abschnitt des Plättchens (10), welcher benachbart zu dem zweiten Ende so geformt ist, dass es eine dünnere Querschnittsfläche aufweist.

11. Bistabiler Aktautor gemäß einem oder mehreren der vorhergehenden Ansprüche, **dadurch gekennzeichnet, dass** das Plättchen aus super elastischem oder pseudoelastischem Material hergestellt ist.

12. Fehlerstromschaltkreisunterbrecher, **dadurch gekennzeichnet, dass** er einen bistabilen Aktuator gemäß einem oder mehreren der vorhergehenden Ansprüche aufweist.

13. Fehlerstromblock, **dadurch gekennzeichnet, dass** er einen bistabilen Aktuator gemäß einem oder mehreren der Ansprüche 1 bis 11 aufweist.

## Revendications

1. Dispositif de commande bistable pour dispositifs à courant résiduel, comprenant :
- un élément de support (12) ;
- une lame métallique (10) qui est dotée d'au moins une couche de matériau piézoélectrique (11) sur au moins l'une de ses faces à une première extrémité de celle-ci, ladite première extrémité étant insérée avec un couplage de verrouillage dans ledit élément de support (12), une seconde extrémité de ladite lame (10), qui est opposée à ladite première extrémité, étant couplée de manière rigide à l'élément de support de façon à maintenir ladite lame (10) dans une première position d'équilibre stable, **caractérisé en ce que** ladite première extrémité et ladite seconde extrémité de ladite lame métallique (10) sont couplées audit élément de support dans des positions mutuellement en quinconce en référence à un plan médian de la lame (10) dans une configuration non déformée.

2. Dispositif de commande bistable selon la revendication 1, **caractérisé en ce que** ladite couche de matériau piézoélectrique (11) est insérée avec un couplage de verrouillage, pour au moins une partie, avec ladite lame (10) dans ledit élément de support (12).

3. Dispositif de commande bistable selon la revendication 1, **caractérisé en ce qu'**il comprend deux couches de matériau piézoélectrique (11) fixées sur les deux faces de ladite lame (10) en correspondance avec ladite première extrémité.

4. Dispositif de commande bistable selon la revendication 1, **caractérisé en ce que** ladite lame (10) a une largeur réduite, au moins en correspondance avec une partie qui est adjacente à ladite seconde extrémité.

5. Dispositif de commande bistable selon la revendication 4, **caractérisé en ce que** ladite lame métallique (10) a deux évidements (16) en correspondance avec ladite partie qui est adjacente à ladite seconde extrémité.

6. Dispositif de commande bistable selon une ou plusieurs des revendications précédentes, **caractérisé en ce que** ladite lame (10) a une largeur réduite, en correspondance avec une partie qui est adjacente à ladite couche de matériau piézoélectrique (11).

7. Dispositif de commande bistable selon la revendication 6, **caractérisé en ce que** ladite lame métallique (10) a deux évidements (16) en correspondance avec ladite partie qui est adjacente à ladite couche de matériau piézoélectrique (11).

8. Dispositif de commande bistable selon une ou plusieurs des revendications 1 à 3, **caractérisé en ce que** ladite lame métallique (10) a un profil fuselé, en correspondance avec une partie qui est adjacente à ladite seconde extrémité.

9. Dispositif de commande bistable selon la revendication 8, **caractérisé en ce que** ladite lame métallique (10) a un profil fuselé, en correspondance avec une partie qui est adjacente à ladite couche de matériau piézoélectrique (11).

10. Dispositif de commande bistable selon une ou plusieurs des revendications 1 à 3, **caractérisé en ce que** ladite lame métallique (10) est formée, au moins en correspondance avec une partie de la lame (10) qui est adjacente à ladite seconde extrémité, de façon à avoir une section transversale plus fine.

11. Dispositif de commande bistable selon une ou plusieurs des revendications précédentes, **caractérisé en ce que** ladite lame est faite en un matériau superélastique ou pseudoélastique.

12. Disjoncteur à courant résiduel **caractérisé en ce qu'**il comprend un dispositif de commande bistable selon une ou plusieurs des revendications précédentes.

13. Bloc à courant résiduel **caractérisé en ce qu'**il comprend un dispositif de commande bistable selon une ou plusieurs des revendications 1 à 11.
